# EUROPÄISCHE PATENTSCHRIFT

(11) **EP 1 116 426 B1**
(45) Veröffentlichungstag und Bekanntmachung des Hinweises auf die Patenterteilung: **10.04.2002**
(21) Anmeldenummer: 99939315.0
(22) Anmeldetag: 25.05.1999
(51) Int. Cl.: H05K 13/04

(54) **VORRICHTUNG ZUM HERSTELLEN VON ELEKTRISCHEN BAUGRUPPEN**
DEVICE FOR PRODUCING ELECTRIC SUB-ASSEMBLIES
DISPOSITIF DE PRODUCTION D'ENSEMBLES ELECTRIQUES

(30) Priorität: 24.09.1998 DE 19843978
(43) Veröffentlichungstag der Anmeldung: 18.07.2001
(73) Patentinhaber: SIEMENS AKTIENGESELLSCHAFT, 80333 München (DE)
(72) Erfinder: MEHDIANPOUR, Mohammad, D-81829 München (DE)
(86) Internationale Anmeldenummer: DE9901540
(87) Internationale Veröffentlichungsnummer: WO0019796

(56) Entgegenhaltungen:
- US-A- 4 630 992
- US-A- 4 910 859
- US-A- 5 694 219

## Beschreibung

Die Erfindung bezieht sich auf eine Vorrichtung zum Herstellen von elektrischen Baugruppen, insbesondere zum Bestücken zumindest eines Bauelementeträgers mit elektrischen Bauelementen, wobei die Vorrichtung zumindest einen in einer Führung gelagerten länglichen Positionierarm für einen Bestückkopf aufweist, der entlang dem Positionierarm verfahrbar ist, wobei der Positionierarm mittels eines Stellantriebs in einer Ebene über einem Bearbeitungsfeld der Vorrichtung verfahrbar ist.

Durch die US4910859 A ist eine Bestückvorrichtung für Bauelemente mit einer Positioniereinrichtung in der Art eines Knickarmroboters bekannt geworden, bei dem der Bestückkopf für die Bauelemente am freien Armende angebracht ist. Die Beweglichkeit in zwei Koordinatenrichtungen wird durch die Überlagerung der Schwenkbewegungen der beiden Armteile erreicht.

Eine hohe Positioniergenauigkeit kann z.B. in einer Bestückvorrichtung nach der bekannten US 5,002,448 A mit kartesischen Linearachsen erreicht werden. Danach ist der Positionierarm über einem Bearbeitungsfeld der Vorrichtung zwischen Bauelementezuführungen und einer zu bestückenden Leiterplatte in einer Linearführung mittels einer Antriebsspindel verfahrbar. Entlang dem Positionierarm ist ein Bestückkopf verfahrbar, der die Bauelemente von peripher angeordneten Zuführeinrichtungen abholt und an den bestimmungsgemäßen Stellen auf den Bauelementeträger aufsetzt.

Um Verkantungen zu vermeiden, ist es üblich, den Positionierarm nur an einem Ende zu führen und am anderen Ende lediglich auf einer Schiene abzustützen, wie dies z.B. durch die US 4,836,111 bekannt geworden ist. Insbesondere im Bereich des ungeführten Endes kommt es durch die auftretenden Beschleunigungs- und Bremskräfte zu Schwingungen, die das genaue Positionieren verzögern. Eine massivere Bauweise des Positionierarmes führt zu einer Gewichtszunahme, die die Massenkräfte erhöht und höhere Anforderungen an das Antriebssystem stellt.

Der Erfindung liegt die Aufgabe zugrunde, die Positionierzyklen zu verkürzen und die Schwingungen im Positionierarm zu verringern.

Diese Aufgabe wird durch die Erfindung gemäß Anspruch 1 gelöst. Durch das Drehlager ist der Positionierarm an einem Ende festgelegt. Die aufwendige Linearführung wird somit durch die einfache, genaue und kompakte Drehführung ersetzt. Der Stellantrieb greift im peripheren Bereich, z.B. am äußeren Ende des Positionierarms an. Nach dem Erreichen der gewünschten Armstellung wird der Positionierarm vom Stellantrieb fixiert, so daß er an dieser Stelle nicht mehr schwingen kann.

Insbesondere bei entsprechenden konstruktiven Voraussetzungen ist es möglich, den Antrieb unmittelbar am äußeren Ende des Positionierarms anzusetzen. Es ist aber auch möglich, die Antriebsteile z.B. im Bereich zwischen der Armmitte und dem äußeren Ende anzusetzen, wodurch eine größere Annäherung an den Masseschwerpunkt erreicht wird

Ein nach der Erfindung zwischen zwei Einspannstellen fixierter Positionierarm wird durch die auftretenden Massenkräfte erheblich geringer auf Biegung belastet, wodurch sich sein Schwingungsverhalten erheblich verbessert. Dadurch verkürzt sich insbesondere beim Einbremsen des Positionierarms die Nachschwingdauer, so daß der anschließende Bearbeitungsvorgang früher beginnen kann. Die Bearbeitungsfrequenz und die Stückleistung erhöhen sich entsprechend.

Es ist üblich, z.B. am Bestückkopf eine optische Abtasteinrichtung z.B. in Form einer CCT-Kamera anzubringen, die den Bauelementeträger nach dem Erreichen der Arbeitsposition vermißt. Dabei wird der Positionierarm schrittweise verfahren und der jeweilige Meßvorgang kann erst nach dem Abklingen der Schwingungen eingeleitet werden. Mit dem schwingungsarmen Positionierarm nach der Erfindung kann das zeitaufwendige Vermessen des Bauelementeträgers erheblich beschleunigt werden.

Der Positionierarm kann erheblich länger und/oder schlanker ausgebildet werden. Besonders vorteilhaft ist es, daß seine Querschnittsabmessungen über die gesamte Länge unverändert bleiben können. Das bedeutet, daß der Positionierarm nicht als aufwendiges Gußteil ausgebildet werden muß. Er benötigt lediglich ein einfaches Strangpreß- oder Walzprofil. Sein Querschnitt und seine Masse verringern sich derart, daß das die erforderlichen Antriebskräfte reduziert werden können, die aufgrund der gegebenen Hebelwirkung noch weiter abgesenkt werden können. Das Antriebssystem kann demzufolge erheblich schwächer ausgebildet werden. Die größere Länge ermöglicht größere Verfahrbereiche und damit die Anordnung größerer Zuführeinrichtungen mit erhöhter Bauteilevielfalt. Die Zuführeinrichtungen können z.B. im äußeren Schwenkbereich des Positionierarms angeordnet werden, wo eine entsprechend lange Abholstrecke zur Verfügung steht.

Vorteilhafte Weiterbildungen der Erfindung sind in den Ansprüchen 2 bis 11 gekennzeichnet.

Durch die Weiterbildung nach Anspruch 2 wird die Winkellage des Positionierarms auf einem Meßkreis mit hoher Genauigkeit ermittelt. Da die Bearbeitungspositionen überwiegend im inneren Schwenkbereich liegen, ergibt sich eine Hebeluntersetzung mit entsprechend erhöhter Positioniergenauigkeit.

Durch die Weiterbildungen nach den Ansprüchen 3 und 4 wird der Positionierarm nicht nur in seiner Verfahrrichtung, sondern auch senkrecht zur Verfahrebene genau fixiert.

Das gemeinsame Schienenteil nach Anspruch 5 vereinfacht den konstruktiven Aufbau der Vorrichtung.

Das Zugmittel nach Anspruch 6, das z.B. nach Anspruch 7 als umlaufender Zahnriemen ausgebildet ist, stellt ein einfaches, massearmes Antriebselement dar, bei dem die mechanische Antriebsenergie durch einen stationären Elektromotor erzeugt werden kann.

Der Linearmotor nach Anspruch 8 ermöglicht es, den Positionierarm mit gleichbleibenden Antriebsbedingungen in einem beliebig großen Winkelbereich zu verfahren.

Durch die Weiterbildung nach Anspruch 9 wird der konstruktive Aufbau der Vorrichtung weiter vereinfacht.

Durch die Weiterbildungen nach den Ansprüchen 10 und 11 können periphere Einrichtungen wie z.B. Bauelementezuführungen der Vorrichtung zu beiden Seiten der linearen Transportstrekke angeordnet werden, ohne daß dadurch der Schwenkbereich des Positionierarms erheblich vergrößert werden muß.

Im folgenden wird die Erfindung anhand eines in der Zeichnung schematisiert dargestellten Ausführungsbeispieles näher erläutert.
- Figur 1: zeigt eine Seitenansicht einer Vorrichtung zum Bestücken von Bauelementeträgern mit elektrischen Bauelementen,
- Figur 2: eine Draufsicht auf die Vorrichtung nach Figur 1,
- Figur 3: einen vergrößerten Teilschnitt entlang der Linie III-III in Figur 1.

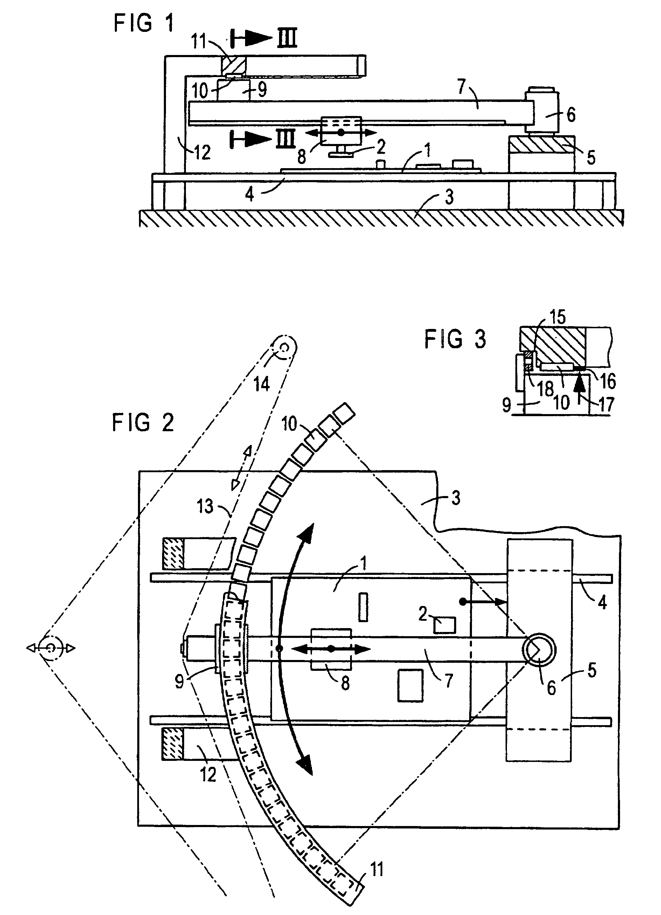

Nach den Figuren 1 und 2 weist eine Vorrichtung zum Bestücken von Bauelementeträgern 1 mit elektrischen Bauelementen 2 ein Chassis 3 auf, auf dem eine lineare Transportstrecke 4 für die als Leiterplatten ausgebildeten Bauelementeträger 1 angebracht ist. Am Chassis 3 ist ferner ein die Transportstrecke 4 überbrückender Träger 5 befestigt, auf dessen Oberseite ein feststehendes Drehlager 6 für einen länglichen Positionierarm 7 angebracht ist. Die Drehachse des Drehlagers 6 steht senkrecht zur Ebene der Transportstrecke 4, auf dem der Bauelementeträger 1 aufliegt. Auf der diesem zugewandten Unterseite des Positionierarms 7 ist ein Bestückkopf 8 angeordnet, der entlang dem Positionierarm 7 gemäß den waagerechten Bewegungsfeilen verfahrbar ist. Der hier dargestellte Bauelementeträger 1 liegt mit seiner Unterseite auf z.B. auf nicht dargestellten umlauffähigen Gurten der Transportstrecke auf und entspricht in seinen Flächenabmessungen einem Bearbeitungsfeld, das hier den Bestückbereich für die Bauelemente bildet.

Der Positionierarm 7 ist parallel zum Bearbeitungsfeld um das Drehlager 6 mittels eines Linearmotors schwenkbar, der aus einem am Positionierarm 7 befestigten Spulenteil 9 und stationären Magnetteilen 10 gebildet ist. Diese erstrecken sich konzentrisch zum Drehlager 6 entlang dem Verfahrweg des Spulenteils 9 und sind an einem ringförmigen Trägerteil 11 befestigt, das mittels zweier Halter 12 am Chassis 3 verankert ist. Das Spulenteil 9 ist im peripheren Bereich auf der dem Bestückkopf 8 abgewandten Oberseite am Positionierarm 7 befestigt. Die Magnetteile 10 sind mit einem geringen Luftspalt oberhalb des Spulenteils 9 angeordnet. Sie erstrecken sich über einen so großen Winkelbereich, daß der Positionierarm 7 mit dem Bestückkopf 8 das gesamte Bearbeitungsfeld überdecken kann.

Der Linearmotor kann mit hoher Winkelgenauigkeit gemäß den gebogenen Bewegungspfeilen verfahren werden. Nach Erreichen einer gewählten Winkelposition wird der Linearmotor in seiner Stellung elektromagnetisch fixiert. Damit ist der Positionierarm 7 im Bereich beider Enden festgehalten, wodurch schädliche Biegeschwingungen weitgehend vermieden werden.

Im linken Bereich der Figur 2 ist strichpunktiert ein anderes Antriebsmittel für den Positionierarm angedeutet. Dabei handelt es sich um einen umlaufenden Zahnriemen 13, der am freien Ende des Positionierarms 7 fixiert werden kann und der über feststehende seitliche Umlenkrollen 14 geführt ist.

Nach Figur 3 weist das Trägerteil 11 eine umlaufende Führungsbahn 15, sowie einen entsprechend gebogenen Winkelmaßstab 16 auf. Am Spulenteil 9 ist eine auf den Winkelmaßstab 16 gerichtete Abtasteinrichtung 17 angeordnet, mittels der die genaue Winkelposition des Positionierarms 7 ermittelt werden kann. Ferner sind am Spulenteil Stützrollen 18 vorgesehen, die sich auf der Führungsbahn 15 abstützen, die sich parallel zur Schwenkebene des Positionierarms erstreckt. Dadurch werden die zwischen dem Spulenteil 9 und den Magnetteilen 10 wirkenden Magnetkräfte abgefangen und der Positionierarm 7 gegen zur Schwenkebene senkrechte Auslenkungen geführt. Werden die Stützrollen in größerem tangentialen Abstand voneinander angebracht, so wird eine aufgrund von exzentrischen Massenkräften verursachte Torsion des Positionierarms 7 verhindert.

## Patentansprüche

1. Vorrichtung zum Herstellen von elektrischen Baugruppen, insbesondere zum Bestücken zumindest eines Bauelementeträgers (1) mit elektrischen Bauelementen (2),
wobei die Vorrichtung zumindest einen in einer Führung (6) gelagerten länglichen Positionierarm (7) für einen Bestückkopf aufweist, der entlang dem Positionierarm verfahrbar ist,
wobei der Positionierarm mittels zumindest eines Stellantriebs (9 und 10,13 und 14) in einer Ebene über einem Bearbeitungsfeld der Vorrichtung verfahrbar ist,
wobei stationäre Antriebsteile (10, 14) der Vorrichtung mit bewegbaren Antriebsteilen (9, 13) zusammenwirken, die mit dem Positionierarm (7) verbunden sind,
wobei die Führung als an der Vorrichtung feststehendes Drehlager (6) für den über dem Bearbeitungsfeld schwenkbaren Positionierarm (7) ausgebildet ist,
**dadurch gekennzeichnet,**
**daß** der Stellantrieb (9, 13) im peripheren Bereich am Positionierarm (7) angeordnet ist und
**daß** die Stellkräfte in diesem Bereich am Positionierarm angreifen.

2. Vorrichtung nach Anspruch 1,
**dadurch gekennzeichnet,**
**daß** im peripheren Bereich des Positionierarms (7) eine Abtasteinrichtung (17) zur Bestimmung der Winkellage angeordnet ist und
**daß** entlang dem Verfahrweg der Abtasteinrichtung (17) ein stationärer bogenförmiger Winkelmaßstab (16) angeordnet ist.

3. Vorrichtung nach Anspruch 1 oder 2,
**dadurch gekennzeichnet,**
**daß** die Vorrichtung im peripheren Schwenkbereich des Positionierarms (7) eine parallel zur Schwenkebene verlaufende, zum Drehlager (6) konzentrische stationäre Führungsbahn (15) aufweist, in der der Positionierarm (7) gegen Auslenkungen aus der Schwenkebene geführt ist.

4. Vorrichtung nach Anspruch 3,
**dadurch gekennzeichnet,**
**daß** der Positionierarm (7) Stützrollen (18) aufweist, die sich senkrecht zur Schwenkebene auf der Führungsbahn (15) abstützen.

5. Vorrichtung nach Anspruch 2,3 oder 4,
**dadurch gekennzeichnet,**
**daß** der Winkelmaßstab und die Führungsbahn (15) an einem gemeinsamen Schienenteil angeordnet sind.

6. Vorrichtung nach einem der vorhergehenden Ansprüche,
**dadurch gekennzeichnet,**
**daß** die bewegbaren Antriebsteile als Zugmittel (13) ausgebildet sind, das im peripheren Bereich am Positionierarm (7) angreift.

7. Vorrichtung nach Anspruch 1,
**dadurch gekennzeichnet,**
**daß** das Zugmittel als von einem Motor angetriebener Zahnriemen (13) ausgebildet ist, der über zu beiden Seiten des Schwenkbereichs angeordnete Umlenkrollen (14) geführt ist.

8. Vorrichtung nach einem der Ansprüche 1 bis 5,
**dadurch gekennzeichnet,**
**daß** der Stellantrieb als Linearmotor ausgebildet ist, dessen bewegbare Antriebsteile als Spulenteil (9) und dessen stationäre Antriebsteile als bogenförmig aneinandergereihte Magnetteile (10) ausgebildet sind, die an einem stationären Trägerteil (11) der Vorrichtung gehalten sind

9. Vorrichtung nach Anspruch 8,
**dadurch gekennzeichnet,**
**daß** die Abtasteinrichtung (17) und die Stützrollen (18) mit dem Spulenteil (9) und
**daß** die Führungsbahn (15) und der Winkelmaßstab (16) mit dem Trägerteil (11) verbunden sind.

10. Vorrichtung nach Anspruch 8 oder 9,
**dadurch gekennzeichnet,**
**daß** eine lineare Transportstrecke (4) für den Bauelementeträger (1) den Achsbereich des Drehlagers (6) durchläuft und
**daß** das Drehlager (6) an einem Träger (5) befestigt ist, der die Transportstrecke (4) brückenartig übergreift.

11. Vorrichtung nach Anspruch 10,
**dadurch gekennzeichnet,**
**daß** die Transportstrecke (4) den Verfahrbereich des Spulenteils (9) kreuzt und
**daß** das Trägerteil die Transportstrecke (4) überbrückt.

## Claims

1. Apparatus for producing electrical subassemblies, in particular for populating at least one component carrier (1) with electrical components (2), the apparatus having at least one elongate positioning arm (7), mounted in a guide (6), for a pick-and-place head which can be moved along the positioning arm,
it being possible for the positioning arm to be moved in one plane over a processing area of the apparatus by means of at least one actuating drive (9 and 10, 13 and 14),
stationary drive parts (10, 14) of the apparatus interacting with movable drive parts (9, 13) which are connected to the positioning arm (7),
the guide being formed as a rotary bearing (6), in a fixed position on the apparatus, for the positioning arm (7) that can be pivoted over the processing area,
**characterized in that** the actuating drive (9, 13) is arranged in the peripheral region on the positioning arm (7) and
**in that** the actuating forces act on the positioning arm in this region.

2. Apparatus according to Claim 1,
**characterized**
**in that** in the peripheral region of the positioning arm (7) there is arranged a sensing device (17) for determining the angular position, and
**in that** along the travel path of the sensing device (17) there is arranged a stationary arcuate angle scale (16).

3. Apparatus according to Claim 1 or 2,
**characterized**
**in that** in the peripheral pivoting region of the positioning arm (7), the apparatus has a stationary guide track (15) which runs parallel to the pivoting plane, is concentric with the rotary bearing (6) and in which the positioning arm (7) is guided against deflections from the pivoting plane.

4. Apparatus according to Claim 3, **characterized**
**in that** the positioning arm (7) has supporting rollers (18) which are supported on the guide track (15), perpendicular to the pivoting plane.

5. Apparatus according to Claim 2, 3 or 4,
**characterized**
**in that** the angle scale and the guide track (15) are arranged on a common rail part.

6. Apparatus according to one of the preceding claims, **characterized**
**in that** the movable drive parts are formed as flexible drive means (13),which acts on the positioning arm (7) in the peripheral region.

7. Apparatus according to Claim 1, **characterized**
**in that** the flexible drive means is formed as a toothed belt (13) which is driven by a motor and is guided over deflection rollers (14) arranged on both sides of the pivoting region.

8. Apparatus according to one of Claims 1 to 5,
**characterized**
**in that** the actuating drive is formed as a linear motor, whose movable drive parts are formed as a coil part (9) and whose stationary drive parts are formed as magnetic parts (10) which are lined up on an arc and are held on a stationary carrier part (11) of the apparatus.

9. Apparatus according to Claim 8, **characterized**
**in that** the sensing device (17) and the supporting rollers (18) are connected to the coil part (9), and
**in that** the guide track (15) and the angle scale (16) are connected to the carrier part (11).

10. Apparatus according to Claim 8 or 9,
**characterized**
**in that** a linear transport path (4) for the component carrier (1) runs through the axial region of the rotary bearing (6) and
**in that** the rotary bearing (6) is fixed to a carrier (5) which reaches over the transport path (4) in the manner of a bridge.

11. Apparatus according to Claim 10, **characterized**
**in that** the transport path (4) crosses the region of travel of the coil part (9) and
**in that** the carrier part bridges over the transport path (4).

## Revendications

1. Dispositif de production de modules électriques, notamment d'implantation de composants (2) électriques sur au moins un support (1) de composants,
le dispositif comportant au moins un bras (7) oblong de positionnement, monté dans un guide (6), pour une tête d'implantation qui peut être déplacée le long du bras de positionnement,
le bras de positionnement pouvant, au moyen d'au moins un actionneur (9 et 10,13 et 14), être déplacé dans un plan au-dessus d'une zone de traitement du dispositif,
des éléments (10, 14) d'actionnement fixes du dispositif coopérant avec des éléments (9, 13) d'actionnement mobiles, qui sont reliés au bras (7) de positionnement,
le guide étant réalisé sous forme de palier (6) de pivotement, fixé sur le dispositif, pour le bras (7) de positionnement pouvant pivoter au-dessus de la zone de traitement,
**caractérisé en ce que** l'actionneur (9, 13) est disposé dans la région périphérique sur le bras (7) de positionnement,
et **en ce que** les forces d'actionnement agissent dans cette région sur le bras de positionnement.

2. Dispositif suivant la revendication 1, **caractérisé en ce qu'**un moyen (17) palpeur est disposé dans la région périphérique du bras (7) de positionnement pour déterminer la position angulaire,
et **en ce qu'**une échelle (16) graduée d'angle, courbe et fixe, est disposée le long de la trajectoire de déplacement du bras (7) de positionnement.

3. Dispositif suivant la revendication 1 ou 2, **caractérisé en ce que** le dispositif comporte, dans la région périphérique de pivotement du bras (7) de positionnement, une glissière (15) fixe, s'étendant parallèlement au plan de pivotement et concentrique au palier (6) de pivotement, dans laquelle le bras (7) de positionnement est guidé pour ne pas dévier hors du plan de pivotement.

4. Dispositif suivant la revendication 3, **caractérisé en ce que** le bras (7) de positionnement comporte des galets (18) d'appui qui s'appuient sur la glissière (15) perpendiculairement au plan de pivotement.

5. Dispositif suivant la revendication 2, 3 ou 4, **caractérisé en ce que** l'échelle graduée d'angle et la glissière (15) sont disposées sur un rail commun.

6. Dispositif suivant l'une des revendications précédentes, **caractérisé en ce que** les éléments d'actionnement mobiles sont réalisés sous forme de moyen (13) de traction, qui agit dans la région périphérique sur le bras (7) de positionnement.

7. Dispositif suivant la revendication 1, **caractérisé en ce que** le moyen de traction est réalisé sous forme de courroie (13) dentée entraînée par un moteur, qui est guidée sur des galets (14) de renvoi disposés des deux côtés de la plage de pivotement.

8. Dispositif suivant l'une des revendications 1 à 5, **caractérisé en ce que** l'actionneur est réalisé sous forme de moteur linéaire, dont les éléments d'actionnement mobiles sont réalisés sous forme de bobine (9) et les éléments d'actionnement fixes sous forme d'éléments (10) d'aimant juxtaposés en courbe, qui sont maintenus sur un élément (11) porteur fixe du dispositif.

9. Dispositif suivant la revendication 8, **caractérisé en ce que** le moyen (17) palpeur et les galets (18) d'appui sont assemblés à la bobine (9), et **en ce que** la glissière (15) et l'échelle (16) graduée d'angle sont assemblées à l'élément (11) porteur.

10. Dispositif suivant la revendication 8 ou 9, **caractérisé en ce qu'**un parcours (4) de transport linéaire pour le support (1) de composants traverse la région axiale du palier (6) de pivotement, et **en ce que** le palier (6) de pivotement est fixé sur un support (5) qui recouvre à la manière d'un pont le parcours (4) de transport.

11. Dispositif suivant la revendication 10, **caractérisé en ce que** le parcours (4) de transport croise la plage de déplacement de la bobine (9), et **en ce que** l'élément porteur surmonte le parcours (4) de transport.
